# EUROPEAN PATENT APPLICATION

(11) **EP 1 536 469 A1**
(43) Date of publication of application: **01.06.2005**
(21) Application number: 03027257.9
(22) Date of filing: 28.11.2003
(51) Int. Cl.: H01L 23/485, H01L 21/60

(54) **Semiconductor device with connecting bumps**

(71) Applicant: EM Microelectronic-Marin SA, 2074 Marin (CH)
(72) Inventor: Simon, Jürgen, 2072 Saint-Blaise (CH)
(74) Representative: Surmely, Gérard

(57) **Abstract**

The semiconductor device (2) comprises bumps for connecting an integrated circuit to a support like a glass plate or a flexible film having electrical contact means. The bumps comprise a base layer (18) of non precious metal, like copper, and a cap layer of precious metal having gold properties with regards to bonding conditions of the semiconductor device to the support, the thickness of this cap layer being greater than 1 µm and sufficient to form a functional layer like conventional gold bumps for the electrical connecting process.

## Description

The present invention concerns the semiconductor domain, and more particularly the bumping technology.

Bumps formed on semiconductor substrates are commonly used for connecting integrated circuits made in these substrates to supports like glass plates or flexible organic films having electrical paths at their surface. In the case of glass supports, a main assembly method is known as Chip On Glass (COG). In the case of plastic films, a main assembly method is known as Chip On Film (COF). A method similar to COF is also used in the Tape Automatic Bonding technique (TAB), also called Tape Carrier Package (TCP).

In most applications, gold bumps are now used because gold is an appropriate material for providing a good electrical connection to the support. Different metals, like copper, have also been used as bump material. Although copper is less expensive, it is harder and less ductile than gold. In particular with increasing chip size, bonding conditions with copper could exceed the fracture strength of these more fragile chips. Further, oxidation problems occur with copper. To solve this last particular problem, patent document US 4,005,472 proposes to protect copper bumps with an antioxidant protective coating layer of gold having a thickness of less than 6000 Angstroms (0.6 µm).

Copper (or copper-nickel) bumps with a thin gold protective layer raise the same problem as copper bumps with regards to their hardness and ductility. For that reason, gold bumps are used since gold has properties well adapted to an efficient interconnecting process in both COG and COF assembly technologies. With gold bumps, a soft interface can be obtained. This soft interface allows in particular high tolerances in the bump height and non planarity of the bonding tool to be compensated.

In the COF technology, interconnections between the bumps and the film are generally made using copper paths or wires coated with a thin tin layer. The tin of the paths or wires and the gold of the bumps form a gold-tin (Au-Sn) eutectic alloy having a melting point of 280 ° C during inner lead bonding. A sufficient amount of gold (20 % in weight) is required for this purpose. The eutectic alloy defined a soft region which protects the chip against overpressure and thus against damages.

In the COG technology, an anisotropic conductive adhesive is used for bonding the chip on the electrical paths or pads of the glass layer. This anisotropic conductive adhesive is made of a non conducting adhesive material in which conductive particles are embedded. In order to make an electrical connection between a bump and a path or pad arranged on the glass facing this bump, the conductive particles have to be pressed between the bump and the path or pad until these particles partially penetrate the bump. It is to be noted that the bump upper surface may not be perfectly planar and that the size of the particles may vary. Thus, a certain deformation of the bump is required for achieving a reliable electrical interconnection. For that reason gold presents very good properties for making such interconnections.

Gold bumping is an established technology. The gold bumps can be formed by electroplating. This technique allows a fine pitch for the bumps arrangement, which is required e.g. for LCD drivers. In the gold bumping industry, the competition has driven the price of bumping step per wafer down. Therefore, cost reduction for manufacturing bumps on semiconductor substrates is now an important issue.

The object of the present invention is to provide semiconductor devices with connecting bumps which are well suited to the different applications and which can be manufactured at reduced costs.

For this purpose, the invention concerns a semiconductor device comprising an integrated circuit and bumps electrically connected to the integrated circuit, the bumps being arranged at an external surface of this integrated circuit for interconnecting this integrated circuit to a support having electrical conductive means, characterized in that each of said bumps is formed by a base layer made of a non precious metal, like copper, in electrical contact with said electrical conductive means and by a cap layer of precious metal, like gold, on top of this base layer, the thickness of this cap layer being greater than one micron (1 µm).

In a preferred embodiment, the thickness of the gold cap layer ranges between 2 µm and 5 µm, this gold cap layer being electroplated on the base layer of the bump.

Thus, the conventional gold bump is replaced by a bump having composite structure with a base layer formed by a low cost material and a functional gold cap layer. By functional gold cap layer, it is understood a cap layer of gold having, for a given application, enough thickness to provide similar electrical bonding conditions with paths or pads on a support or inner wires extending in an opening of a support compared to conventional gold bumps, in particular a low hardness in the bonding region and a high ductility. Therefore, a bump with a copper base layer and a functional gold cap layer provides gold properties at the bonding interface, which is not the case with a protective anti-corrosion layer having a thickness of less than 6000 Angstroms. A further advantage is that the quantity of gold used will be independent of the height of the bump to be formed, e.g. between 15 µm and 30 µm.

It is to be noted that the composite structure of the bump can be preferably electroplated using the same photoresist layer thereby maintaining the costs of the process low.

In a preferred embodiment, the plating base will also be formed of copper (no longer with gold), which results in an even greater cost reduction.

One preferred embodiment of the semiconductor device according to the present invention and the method of manufacturing such a device will now be described solely by way of example, with reference to the accompanying drawings, in which :
- Figure 1 is a partial cross-section of this preferred embodiment, and
- Figure 2 is a view similar to figure 1, but at an intermediate stage of the manufacturing process of the bumps of the semiconductor device.

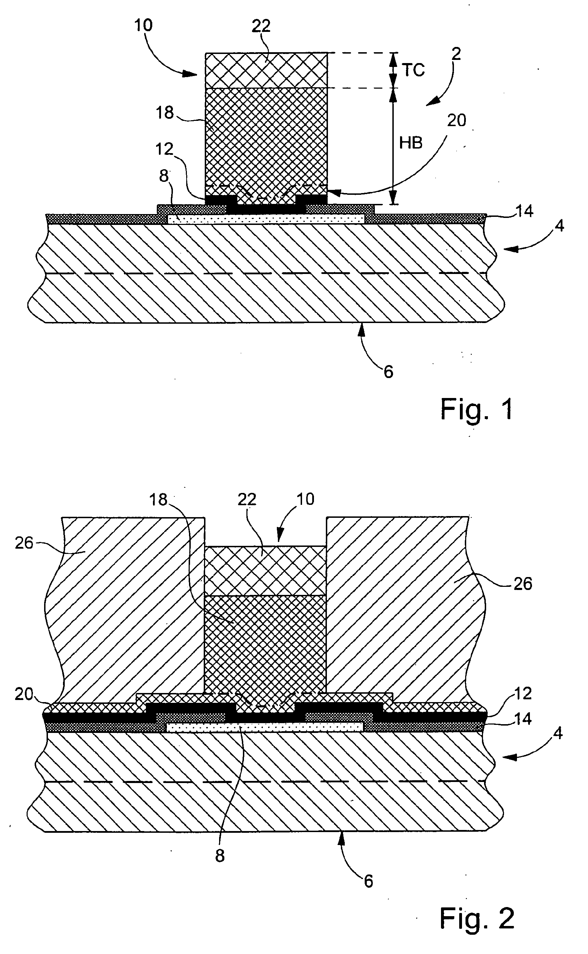

The semiconductor device 2, partially represented on Figure 1, comprises an integrated circuit 4 in a semiconductor substrate 6. On top of the integrated circuit, a structured metallization layer is deposited with contact pads 8. At least a part of these pads are in electrical contact with external bumps 10, these bumps being used for inner lead bonding in order to interconnect the integrated circuit with a support of the device. At the bottom of the bump 10, a barrier layer 12, e.g. of TiW, is sputtered on pad 8 and partially on a passivation layer 14.

Bump 10 comprises a base layer 18 of a non precious metal, like copper. The bottom portion 20 of this base layer 18 comes from a seed layer deposited on barrier layer 12. The height HB of the base layer can vary depending on the application, but is preferably greater than ten microns (10 µm). Above base layer 18 is cap layer 22 of a precious metal like gold, i.e. gold or another metal or alloy having similar mechanical and electrical properties to those of gold with regards to bonding of bumps with wires or pads, in particular by metallic joint or with an anisotropic conductive adhesive. This cap layer 22 has a thickness TC greater than one micron (1 µm), preferably between 2 µm and 5 µm, and thus has properties relative to bonding conditions which are similar to those of conventional gold bumps.

Referring now to Figure 2, a method for manufacturing semiconductor device 2 of Figure 1 will be described.

In semiconductor substrate 6, integrated circuit 4 is manufactured by a known method. On top of this circuit, a structured metallization layer 8 is deposited in a known manner, e.g. by a PVD process. Then a passivation layer 14 is deposited on the structured layer 8 and apertures are formed in this layer 14 in order to define electrical contact zones for external bumps 10.

Then a barrier and adhesion layer 12 is sputtered and a plating base 20 for the following formation of bumps 10 is deposited. For conventional gold bumps, this plating base is generally made of gold. But in the case of the present invention, layer 20 is preferably made of a non precious metal, in particular of copper.

In a following step, a photoresist mask 26 is deposited and structured in order to form openings for electroplating bumps 10. First, the base layer 18 is electroplated with a non precious metal, in particular copper. By using the same photoresist mask, gold cap layer 22 is then electroplated on top of base layer 18. This subsequent plating is preferably made without any drying step, i.e. by a wet to wet process.

Because copper may dissolve in the gold bath and contaminate it, an electrical voltage may be applied to the semiconductor device before inserting it in the gold plating bath. Thanks to this step in the manufacturing method, base 18 is electrically charged thereby avoiding a dissolution of copper in the gold bath.

Finally, the photoresist mask 26 is eliminated and the barrier layer 12 as well as the seed layer 20 are removed outside bumps zones.

## Claims

1. Semiconductor device (2) comprising an integrated circuit (4) and bumps (10) electrically connected to the integrated circuit, said bumps being arranged at an external surface of this integrated circuit for interconnecting this integrated circuit to a support having electrical conductive means, **characterized in that** each of said bumps comprises a base layer (18) made of a non precious metal, like copper, in electrical contact with said electrical contact means and a cap layer (22) of precious metal, like gold, on top of this base.layer, the thickness (TC) of this cap layer being greater than one micron (1 µm).

2. Semiconductor device according to claim 1, **characterized in that** said thickness of said cap layer (22) ranges between 2 µm and 5 µm.

3. Semiconductor device according to claim 1 or 2, **characterized in that** said cap layer (22) is electroplated.

4. Semiconductor device according to any one of claims 1 to 3, **characterized in that** the height (HB) of said base layer is greater than ten microns (10 µm).

5. Semiconductor device according to any one of claims 1 to 4, **characterized in that** it comprises a seed layer (20) arranged at the bottom of said bumps on top of a barrier layer (12), this seed layer being formed of a non precious metal, like copper.
